# EUROPEAN PATENT APPLICATION

(11) **EP 4 752 918 A1**
(43) Date of publication of application: **03.06.2026**
(21) Application number: 25212937.4
(22) Date of filing: 03.11.2025
(51) Int. Cl.: H01F 27/28, H10W 90/00, H10W 72/00

(54) **GALVANICALLY ISOLATED COMMUNICATION LINKS USING COILS FABRICATED IN MOLDING COMPOUND**

(30) Priority: 27.11.2024 US 202418961976
(71) Applicant: NXP USA, Inc., Austin, TX 78735 (US)
(72) Inventor: Shah, Ankur Shailesh, 5656AG Eindhoven (NL); Vincent, Michael B, 5656AG Eindhoven (NL); Gong, Zhiwei, 5656AG Eindhoven (NL)
(74) Representative: Colaiuda, Antonella

(57) **Abstract**

A packaged device includes molding compound, a first semiconductor die disposed within the molding compound and a second semiconductor die disposed within the molding compound. The molding compound galvanically isolates the first and second semiconductor dies. The packaged device further includes communication coils constructed and arranged to provide communication between the first and second semiconductor dies through inductive coupling, at least one of the communication coils being fabricated within the molding compound.

## Description

### TECHNICAL FIELD

This disclosure relates generally to package structures, and more particularly to packaged devices with coils that enable communication via inductive coupling.

### BACKGROUND

Galvanically isolated integrated circuits may communicate wirelessly. For example, two galvanically isolated integrated circuit dies may have respective die coils that can be used to communicate through inductive coupling.

Along these lines, first die coils may be fabricated on a top metal layer of a first integrated circuit die and second die coils may be fabricated on a top metal layer of a second integrated circuit die. The first and second die coils are then positioned in close proximity and aligned to enable communication via inductive coupling while the first and second integrated circuit dies remain galvanically isolated.

Galvanically isolated circuit die are frequently encapsulated within molding material to form a molded device package which can protect the devices from damage and provide macroscopic external contacts that are exposed on surfaces of the package.

### BRIEF DESCRIPTION OF THE DRAWINGS

The foregoing and other objects, features and advantages will be apparent from the following description of particular embodiments of the present disclosure, as illustrated in the accompanying drawings in which like reference characters refer to the same parts throughout the different views. The drawings are not necessarily to scale, emphasis instead being placed upon illustrating the principles of various embodiments of the present disclosure.
FIG. 1 is cross-sectional illustration of an example packaged device which includes coils fabricated within molding compound in accordance with one or more embodiments.
FIG. 2 is a flowchart of a procedure of providing an example packaged device including coils fabricated within molding compound in accordance with one or more embodiments.
FIGS. 3 through 6 are views of an example process flow in accordance with one or more embodiments.
FIGS. 7 through 12 are cross-sectional illustrations of alternative example packaged devices in accordance with one or more embodiments.
FIG. 13 is a cross-sectional view of an example packaged device having general structures in accordance with one or more embodiments.

### DETAILED DESCRIPTION

Die coils fabricated on the top metal layers of integrated circuit dies may consume significant die space. Additionally, other die structures such as wire bonding pads may compete for such space. Moreover, for coil alignment that properly achieves inductive coupling, the positioning of die coils on one die may impose requirements and/or restrictions for the positioning of die coils on the other die. Unfortunately, these spacing constraints may result in sub-optimal die geometries, sizes, and/or layouts, which can result in increased manufacturing costs and/or reduced performance. Accordingly, there is a need for a more flexible way to arrange inductive coupling coils to enable communication between galvanically isolated dies.

Such a need is addressed at least in part by fabricating conductive communication coils within molding compound that is used to provide galvanic isolation between semiconductor dies. The molding material can also form part of a molded package in which two or more dies are packaged together. Such coil fabrication within the molding compound enables coils to be located off the dies and in the molding compound if desired, thus removing die spacing constraints. Additionally, such coil fabrication within the molding compound provides flexibility to position the coils at optimal locations within packages. Furthermore, such coil fabrication within the molding compound provides improved ability to control certain details such as coil sizes, distances between the coils, dielectric strength of the separating material between the coils, and so on.

Communication between galvanically isolated semiconductor dies can be achieved by inductively coupling conductive communication coils. This type of communication is referred to herein as Galvanically Isolated Communication Linkage (GICL). The size of the coils (and/or an amount of signal power) used for GICL may be influenced by the distance and/or dielectric strength of the insulating material between the coils. For example, for a given signal voltage, a smaller distance between inductively coupled coils will enable use of smaller coils, which in turn may enable a reduction in overall package size. Similarly, use of insulating material with greater dielectric strength enables the coils to be positioned even closer together, thereby enabling a further reduction in overall package size.

Communication coils and electrical interconnections between such coils and can be fabricated within the molding compound using any suitable technique. For example, suitable techniques involving mechanically and/or chemically forming various features such as bores, trenches, channels, etc. within the molding compound include drilling, sawing, ablation, and etching. Deposition is then performed to build conductive elements within these features by means such as electroplating, electroless plating, printing, spraying, dispensing, and the like.

Another suitable technique for fabricating communication coils within molding compound is to laser-activate areas of the molding compound and then to form metallic structures at the laser-activated areas using a metallization process. Such laser-activation causes the laser-activated areas of the molding compound to become highly receptive to metal deposition during the metallization process (e.g., via laser-activation of a metallic additive within the molding compound). Accordingly, various metallic structures may be built within the molding compound, such as communication coils, trace connections (or simply traces), and through-molding vias (TMVs).

The various individual features of the particular arrangements, configurations, and embodiments disclosed herein can be combined in any desired manner that makes technological sense. Additionally, such features are hereby combined in this manner to form all possible combinations, variants and permutations except to the extent that such combinations, variants and/or permutations have been expressly excluded or are impractical. Support for such combinations, variants and permutations exists within this document as would be clear to one skilled in the art in light of this disclosure.

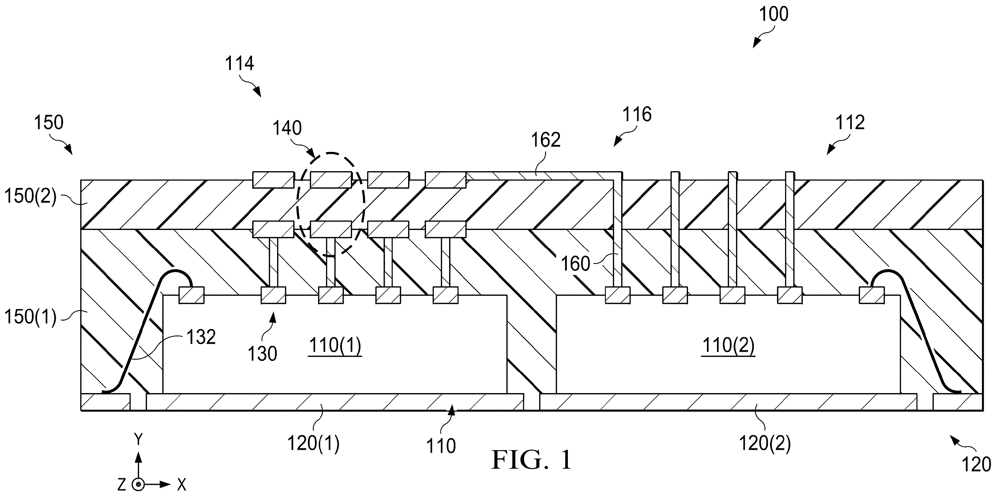

FIG. 1 shows a cross-section of an example packaged device 100 which includes coils fabricated within molding compound in accordance with one or more embodiments. Such a packaged device 100 enables galvanically isolated semiconductor dies to communicate via inductive coupling while removing spacing constraints of conventional approaches.

The example packaged device 100 includes a first semiconductor die 110(1), a second semiconductor die 110(2), and molding compound 112 within which the first and second semiconductor dies 110(1) and 110(2) (collectively, semiconductor dies 110) are disposed. The packaged device 100 further includes communication coils 114 which are fabricated within the molding compound 112, as well as other structures 116.

The semiconductor dies 110 include various die structures and are constructed and arranged to perform useful work. Along these lines, the semiconductor dies 110 may include substrates, various conductive and non-conductive structures formed within and/or on the substrates, additional layers, metallizations, coatings, and so on.

As shown in FIG. 1, the bottom surfaces of the semiconductor dies 110 attach (or mount) to respective portions of a lead frame 120. Also, the top surfaces of the semiconductor dies 110 include electrical contact pads ("pads") 130 which provide electrical access to the semiconductor dies 110. That is, the bottom surface of the first semiconductor die 110(1) attaches to a first portion 120(1) of the lead frame 120, and the top surface of the first semiconductor die 110(1) includes pads 130 to provide electrical access to the first semiconductor die 110(1). Similarly, the bottom surface of the second semiconductor die 110(2) attaches to a second portion 120(2) of the lead frame 120, and the top surface of the second semiconductor die 110(2) includes pads 130 to provide electrical access to the second semiconductor die 110(2). It should be understood that nothing precludes the packaged device 100 from including one or more additional semiconductor dies 110.

The pads 130 (e.g., for wire bonding, for connecting to coils, etc.) may be formed on metallization layers of the semiconductor dies 110. For illustration purposes, FIG. 1 shows, on the top surface of each semiconductor die 110, a pad 130 which serves as a bond pad and an associated wire 132 which electrically connects the bond pad to a respective portion (or segment) of the lead frame 120 (e.g., for a power connection, a ground connection, a signal connection, etc.). However, it should be understood that the top surface of each semiconductor die 110 may include multiple pads 130 (any number of bond pads may be included) which are wire bonded to the lead frame 120 (e.g., for power, ground, input/output (I/O), combinations thereof, etc.).

Additionally, some of the pads 130 of the semiconductor dies 110 serve as coil pads and connect with the communication coils 114 fabricated within the molding compound 112 (any number of coil pads may be included). In accordance with one or more embodiments, there is at least one pad 130 of at least one semiconductor die 110 that electrically connects with a respective communication coil 114 fabricated within the molding compound 112. In the cross-sectional view of FIG. 1 and by way of example only, there are four pads 130 on the top surface of each die 110 which electrically connect with respective communication coils 114 fabricated within the molding compound 112. However, it should be understood that each die 110 may include a different number of pads that electrically connect with communications coils 114 (e.g., one, two, three, six, etc.).

The molding compound 112 is constructed and arranged to galvanically isolate the dies 110 from each other. Along these lines, the molding compound 112 may include molding material (at any thickness) which provides specified dielectric insulation qualities. For example, the molding compound 112 may be constructed and arranged to withstand a voltage >5000 Volts without breaking down, thus enabling the dies 110 to operate in different voltage domains and to withstand large voltage transients without damaging either die 110.

In accordance with one or more embodiments, the molding compound 112 covers large portions of the dies 110 (e.g., at least the top surfaces, substantially five sides of each die 110, etc.). In one or more embodiments, the molding compound 112 includes multiple layers 150 of molding material which may be formed of the same molding material, or of different molding materials. As shown in FIG. 1, the molding compound 112 includes two layers 150(1) and 150(2) but it should be understood that the molding compound 112 may include a different number of layers 150 (e.g., one, three, four, etc.).

For the layer arrangement of FIG. 1, the molding compound 112 includes a lower layer 150(1) of molding material which substantially surrounds (or encapsulates) the dies 110. The lower layer 150(1) may reside around the semiconductor dies 110 on five sides (e.g., except for the bottoms of the semiconductor dies 110). Accordingly, the lower layer 150(1) of molding material provides structural support and/or protection while serving as dielectric insulation between the dies 110. Additionally, the lower layer 150(1) may provide similar structural support and/or protection for other structures of the packaged device 100 (e.g., for bonding wires).

Additionally, an upper layer 150(2) of molding material is disposed over the lower layer 150(1) of molding material. As will be explained in further detail below, the upper and lower layers 150 of molding material operate as a medium within which various conductive structures are fabricated (e.g., communication coils, metallic vias, traces, and so on).

The communication coils 114, which are fabricated within the molding compound 112, are constructed and arranged to enable GICL. Along these lines, a communication coil 114 that electrically connects with the first semiconductor die 110(1) may be positioned adjacent to another communication coil 114 that electrically connects with the second semiconductor die 110(2) to form an inductively coupled coil pair 140. Other communication coils 114 may be similarly arranged to form other inductively coupled coil pairs 140.

The sizes of the communication coils 114 and the distances between the communication coils 114, among other things, influences GICL effectiveness. For example, for a given amount of power, larger coil sizes and lesser distance between the communication coils 114 of an inductively coupled coil pair 140 improves GICL strength.

It should be understood that the packaged device 100 may include other structures 116, such as though-molding vias (TMVs) 160 and molding traces 162, which are fabricated within the molding compound 112. A TMV 160 is a vertical conductive pathway that penetrates through a layer 150 of molding material parallel to the Y-axis in FIG. 1. A molding trace 162 is a conductive pathway that extends along a layer of molding material parallel to the X-Z plane in FIG. 1. Such TMVs 160 and molding traces 162 electrically couple the pads 130 of the semiconductor dies 110 with the communication coils 114. The structures 116 may include other metallic features as well such as shielding structures, inter-die connecting structures, and so on.

It should be appreciated that the structures 116 (e.g., metallic traces, metallic vias, etc.) within the layers 150 of molding material enable the communication coils 114 to be moved (or relocated). Along these lines, such a feature provides great flexibility to enable positioning of the communication coils 114 at optimal locations within the packaged device 100.

In accordance with one or more embodiments and as will be explained in further detail shortly, the communication coils 114, the TMVs 160, and the molding traces 162 are fabricated within the molding compound 112 using a metallization process. Such a process deposits conductive material onto locations within the molding compound to build-up these metallic electrical structures. In some arrangements, a laser is applied to the locations to bore holes and/or form indents, to promote metallic affinity at these locations (e.g., to activate an additive within the molding material which can create nucleation sites for metal deposition via a plating process), and so on.

It should be appreciated that use of the communication coils 114 removes various spacing constraints that would otherwise be present. Along these lines, with one or more communication coils 114 fabricated within the molding compound 112 rather than on the surface of a die, there is more freedom to locate the communication coils 114 within the packaged device 100 (e.g., within the molding compound 112). Additionally, there is more freedom to place pads 130 on the dies 110. Furthermore, the dies 110 do not need to be tightly stacked, and the dies 110 can instead be placed in a side-by-side arrangement as shown in FIG. 1, since there is no longer a need for die coils to align with each other. Moreover, as a result of removing the requirement for coils to be disposed on each die, it is now possible to make the top surfaces of the dies 110 smaller thus reducing package device dimensions.

It should be appreciated that the off-die communication coils 114 are well-suited for a packaged device 100 having semiconductor dies 110 that operate in significantly different voltage domains. For example, and not by way of limitation, the first semiconductor die 110(1) may include digital control circuitry to operate in a relatively low voltage domain (e.g., less than 10 Volts), and the second semiconductor die 110(2) may include high voltage circuitry to operate in a relatively high voltage domain (e.g., at hundreds of Volts) enabling a packaged device 100 having the dies 110(1), 110(2) to drive an inverter or a motor (e.g., for an electric vehicle) and so on, while protecting low-voltage circuit elements from damage by exposure to excessively large induced voltages from neighboring high voltage circuits or unintended current discharges caused by dielectric breakdown between two circuit elements in separate voltage domains.

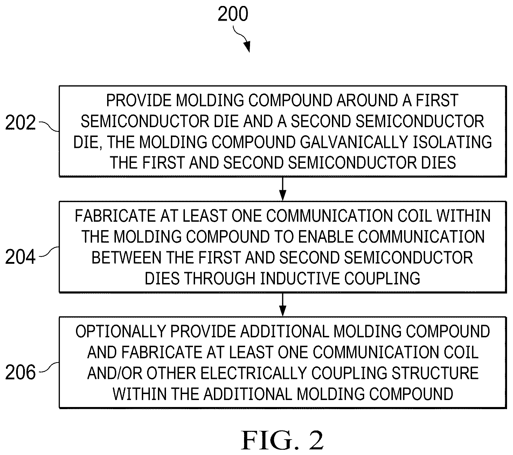

It should be further appreciated and in accordance with one or more embodiments, one or more semiconductor dies 110 include wireless communication circuitry, and one or more communication coils 114 is electrically coupled with the wireless communication circuitry. For example, one or more of communication coils 114 may be coupled to transmitter circuits, receiver circuits, transceiver circuits, or the like. In some embodiments, a pad 130 may be electrically coupled with one or more circuit nodes within a semiconductor die 110 that supplies power to circuits within semiconductor dies 110. In these embodiments, when a voltage is applied to a pad 130, power may be supplied to circuits within a semiconductor die 110, such as control circuits, transmitter circuits, receiver circuits, transceiver circuits, or the like. Further details will now be provided with reference to FIG. 2.

FIG. 2 is a flowchart of a procedure 200 of providing a packaged device including coils fabricated within molding compound in accordance with one or more embodiments (e.g., also see FIG. 1). Such a procedure 200 enables the molding compound to provide galvanic isolation between semiconductor dies of the packaged device, but also enables the coils to be located off of the semiconductor dies thus removing semiconductor die spacing constraints that could otherwise impact die size, restrict pad placement and die positioning relative to each other, and so on.

At 202, molding compound is provided around a first semiconductor die and a second semiconductor die. The molding compound is configured and arranged to galvanically isolate the first and second semiconductor dies. Molding material which is suitable for use is epoxy mold compound (EMC). Such material flows easily, may be easily molded and cured into any suitable shape, may be bored with high precision, and so on. Other molding material such as those mainly composed of polyester, vinyl ester, silicone, urethane, and the like may be suitable for use as well.

At 204, at least one communication coil is fabricated within the molding compound to enable communication between the first and second semiconductor dies through inductive coupling. A suitable process for forming a communication coil within the molding compound is metallization in which conductive material is deposited over specific areas of the molding compound.

In some embodiments, a communication coil is fabricated via a laser structuring process. Along these lines, the molding compound includes an additive such that an area that is laser-activated then has increased metal affinity to enable metallic structures to be built up via a suitable deposition process (e.g., a plating process). The communication coil can then be created via an electroless plating process.

It should be understood that, during coil fabrication within the molding compound, one or more other structures may be fabricated within the molding compound as well. Such structures include through-molding vias (TMVs) and molding traces (e.g., using laser-activation, electroplating, etc.).

Additionally, after 204 is performed and at 206, similar activities may be performed to further buildup the molding compound and fabricate other structures. As a result, the molding compound may include multiple layers of molding material and various conductive structures fabricated within the layers.

Along these lines, one or more communication coils and one or more similar structures (e.g., TMVs and/or molding traces) may be fabricated on and/or in a first layer of molding material (see 202 and 204 in FIG. 2). Then, one or more other communication coils and one or more other similar structures may be fabricated on and/or in a second layer of molding material disposed over the first layer, etc. (see 206 in FIG. 2).

Accordingly, the procedure 200 enables one layer of molding material to be disposed between a die and a first communication coil. Additionally, the procedure 200 enables another layer of molding material to be disposed between the first communication coil and a second communication coil, etc. Such acts may provide a network (or fabric) of conductive pathways through the molding compound.

In one or more embodiments, other materials/structures/etc. may be positioned with one or more layers of molding material. For example, a segment of material having a dielectric strength (at any thickness) greater than that of the molding material may be disposed on top of a first set of coils (one or more coils) before a second set of coils is disposed on top of the segment. Such a situation provides an inductively coupled coil pair with a higher dielectric strength between coils compared to simply using molding material for galvanic isolation between the coils.

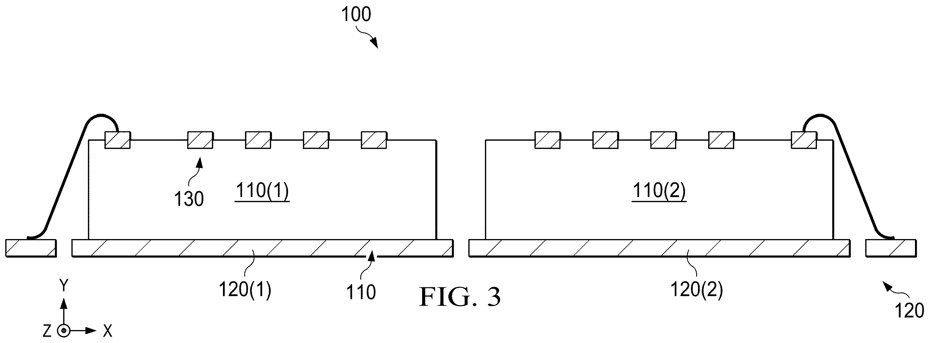

It should be understood that the procedure 200 is suitable for providing multiple packaged devices in parallel. Along these lines, the devices (even while in partial form) may be units of a fixed panel and may be processed together. Such processing may involve common fabrication steps, testing steps, and so on to process multiple packaged devices together prior to singulation. Further details will now be provided with reference to FIGS. 3 through 6.

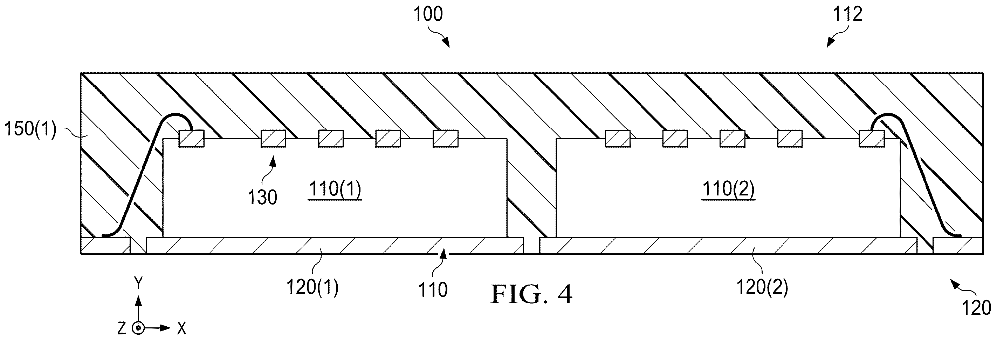

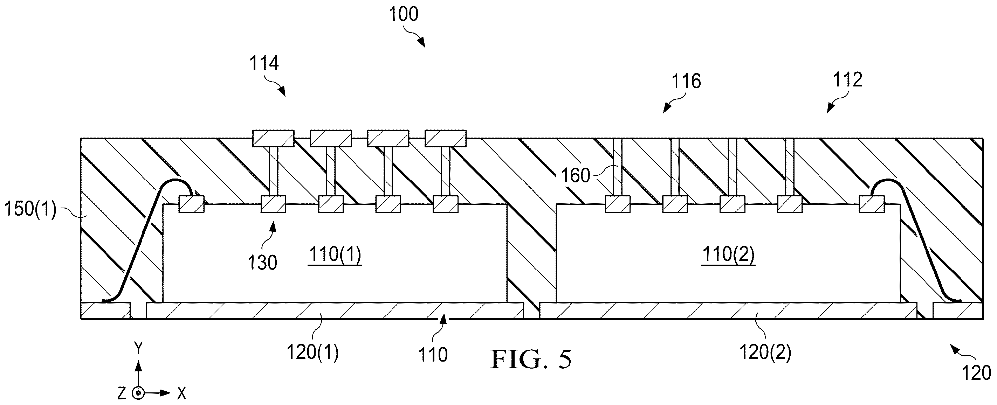

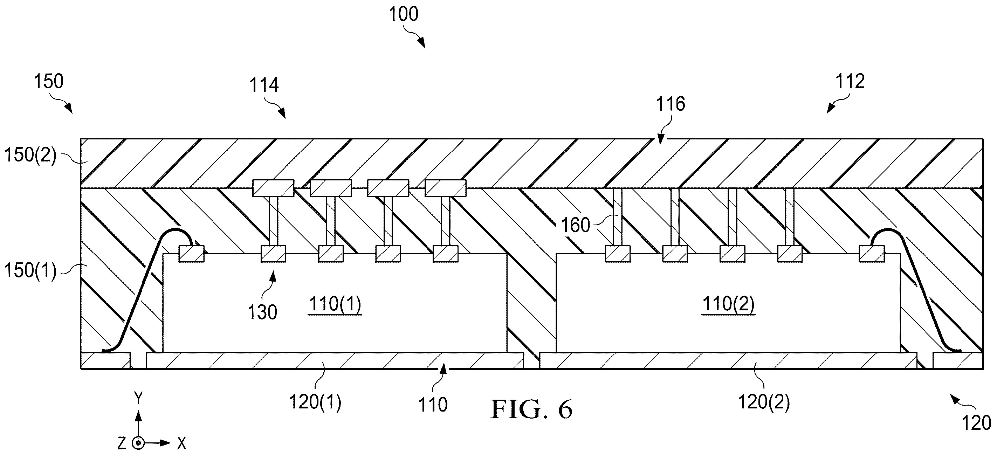

FIGS. 3 through 6 show cross-sections of a packaged device at different points during performance of the procedure 200 (also see FIG. 2) in accordance with one or more embodiments. FIG. 3 shows multiple semiconductor dies at an early part of the process flow. FIG. 4 shows a first layer of molding compound covering the multiple semiconductor dies at a next part of the process flow. FIG. 5 shows communication coils and other structures fabricated within the first layer of molding compound at another part of the process flow. FIG. 6 shows a second layer of molding compound covering the first layer of molding compound, and additional communication coils and other structures fabricated within the second layer of molding compound at yet another part of the process flow. By way of example only, the process flow provides the example packaged device 100 as shown in FIG. 1.

As shown in FIG. 3 and as mentioned earlier, the semiconductor dies 110 have top surfaces and bottom surfaces. The top surfaces of the semiconductor dies 110 have pads 130 to provide electrical access to the semiconductor dies 110.

The bottom surfaces of the semiconductor dies 110 are attached to portions of the lead frame 120 at the early part of the process flow 300. Here, the bottom surface of the first semiconductor die 110(1) is attached to the first portion 120(1) of lead frame 120. Likewise, the bottom surface of the second semiconductor die 110(2) is attached to the second portion 120(2) of lead frame 120. Furthermore, certain pads 130 are wire bonded to portions of the lead frame 120.

At this point in the process flow, the semiconductor dies 110 are ready for encapsulation. During this process and as shown in FIG. 4, a layer 150(1) of molding material (e.g., EMC or similar material) is provided over the semiconductor dies 110 to form a first layer 150(1) (also see 202 in FIG. 2). In some embodiments, the molding material is disposed around five sides of each die 110.

It should be understood that, during this part of the process flow, the tops of the semiconductor dies 110 and the bonding wires are completely within with molding material. The molding material then hardens (or cures), forming at least some of the molding compound 112 which provides galvanic isolation between the dies 110 (also see FIG. 1).

As shown in FIG. 5, various metallic structures are then fabricated within the first layer 150(1) of molding compound (also see 204 in FIG. 2). Such structures include certain communication coils 114 and certain other structures 116 such as TMVs 160 which serve as electrical paths to certain pads 130 of the semiconductor dies 110. Accordingly, a portion of the first layer 150(1) of molding material is disposed between the top surface of the semiconductor die 110(1) and the fabricated communication coils 114.

It should be understood that the communication coils 114 are metallic structures which may be formed via electroless plating, although electroplating, printing, spraying and dispensing may be suitable for use as well. For the TMVs 160, bores (or penetrations) along the Y-axis are initially formed within the layer 150(1) of molding material from the outer surface to the pads 160 (e.g., via laser drilling). Although there are no traces shown in this example, traces parallel to the X-Z plane may be fabricated on the layer 150(1) as well. Suitable conductive metals for the metallic structures include copper, aluminum, gold, combinations thereof, and the like.

In some embodiments, certain metallic structures are provided via laser structuring. Along these lines, the areas of the molding compound 112 on which the metallic structures are fabricated are laser-activated. Here, the molding material may include an additive such that, when a location of the molding material is struck by a laser, the location has an increased affinity for metallization.

Next, as shown in FIG. 6, additional molding material (e.g., EMC or similar material) covers the first layer 150(1) and the metallic structures which were fabricated within the first layer 150(1) to form the second layer 150(2) of molding material. The second layer 150(2) then hardens to serve as a further portion of the molding compound 112.

It should be understood that the molding material that forms the first layer 150(1) and the second layer 150(2) are not required to be the same. In one or more embodiments, the molding material that forms the first layer 150(1) and the second layer 150(2) is the same to provide the same or similar properties (e.g., breakdown characteristics, mechanical characteristics, combinations thereof, etc.). In one or more other embodiments, the molding material that forms the first layer 150(1) and the second layer 150(2) is different to provide the different properties (e.g., customized breakdown characteristics, customized mechanical characteristics, combinations thereof, etc.).

At this point, additional metallic structures may be formed within the second layer 150(2) of molding material. Again, such metallic structure may include communication coils 114, TMVs 160, traces 162, and so on. It should be appreciated that the additional process flows of FIGS. 5 and 6 is described at 206 in the procedure 200 (e.g., also see FIG. 2).

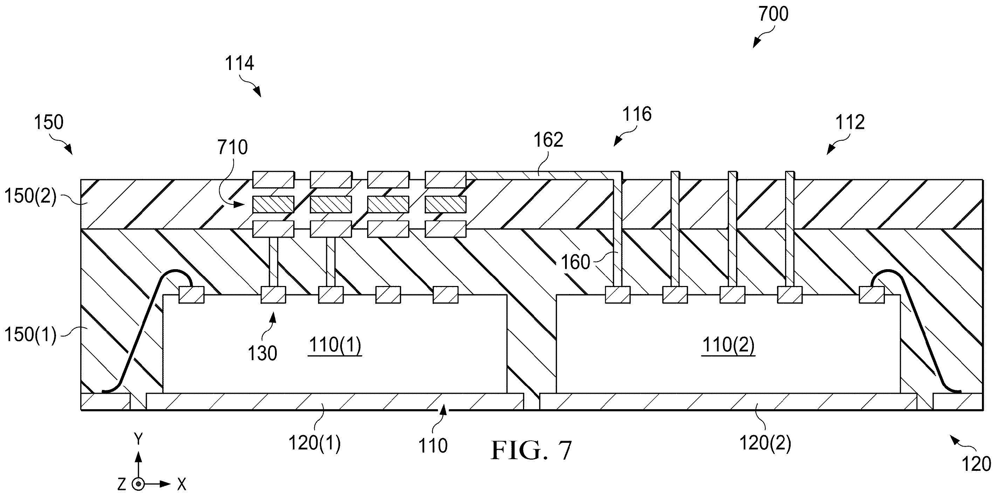

Upon completion of the process flows, there is a packaged device having semiconductor dies 110 galvanically isolated by molding compound 112, and at least one communication coil 114 fabricated within the molding compound 112 for inductive coupling. For example, FIG. 1 shows an example packaged device 100 having multiple communication coils 114 fabricated within the molding compound 112. Such communication coils 114 enable GICL to be achieved. Further details will now be provided with reference to FIGS. 7 through 12.

FIGS. 7 through 12 show alternative example packaged devices in accordance with certain embodiments. Such alternative example packaged devices include at least one communication coil 114 formed within the molding compound 112 that galvanically isolates semiconductor dies 110.

FIG. 7 shows an example packaged device 700 which is similar to the example packaged device 100 of FIG. 1. Like reference characters refer to the same or similar parts among the example packaged devices 100, 700.

As shown in FIG. 7, the example packaged device 700 includes individual segments 710 of high breakdown material disposed between the communication coils 114. The high breakdown material has a higher dielectric strength than that of the molding compound 112.

In one or more embodiments, the molding compound can withstand a voltage >5000 Volts without breaking down, and the high breakdown material can withstand even higher voltage without breaking down. Other dielectric strengths and/or ranges for the molding compound and for the high breakdown material are suitable for use as well.

The individual segments 710 may be installed within the packaged device 700 using standard techniques. Such techniques may include pick and place installation, doping, deposition processes, other fabrication processes, combinations thereof, and so on.

The higher breakdown characteristic of the segments 710 enables other optimizations. For example, signal power may be increased without changing the sizes of the communication coils 114 or increasing the distance in the Y-direction between the communications coils 114. Alternatively, for the same signal strength, the sizes of the communication coils 114 and/or the distance in the Y-direction between the communications coils 114 may be decreased to enable a smaller overall package size.

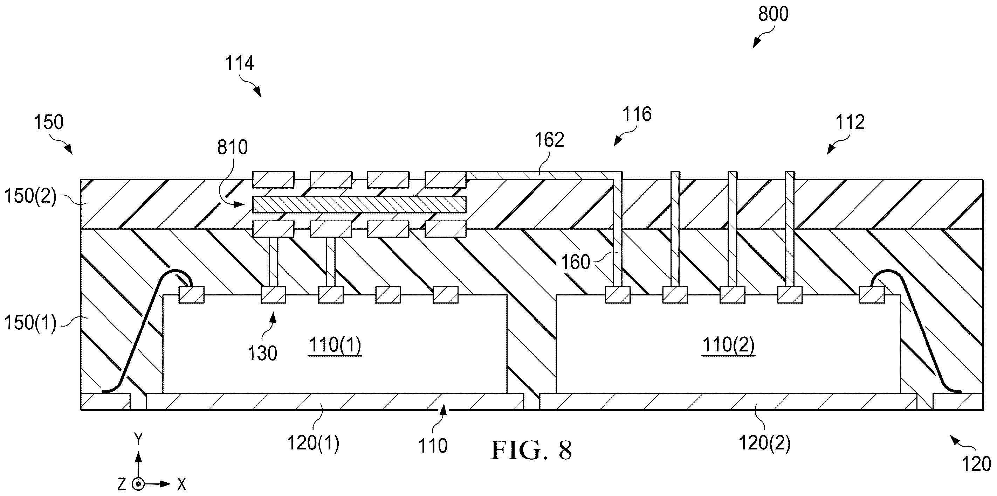

FIG. 8 shows an example packaged device 800 which is similar to the example packaged device 700 of FIG. 7. Like reference characters refer to the same or similar parts among the example packaged devices 700, 800.

As shown in FIG. 8, the example packaged device 800 includes a common segment 810 of high breakdown material disposed between multiple communication coils 114 electrically coupled with the first semiconductor die 110(1) and multiple coils 114 electrically coupled with the second semiconductor die 110(2). Again, the high breakdown material has a higher dielectric strength than that of the molding compound 112.

The common segment 810 may be installed within the packaged device 700 using standard techniques. Such techniques may include pick and place installation, doping, deposition processes, other fabrication processes, combinations thereof, and so on.

For reasons similar to those described above for the individual segments 710 in FIG. 7, the higher breakdown characteristic of the segment 810 enables other optimizations. For example, signal power may be increased without changing the sizes of the communication coils 114 or increasing the distance in the Y-direction between the communications coils 114. Alternatively, for the same signal strength, the sizes of the communication coils 114 and/or the distance in the Y-direction between the communications coils 114 may be decreased to enable a smaller overall package size.

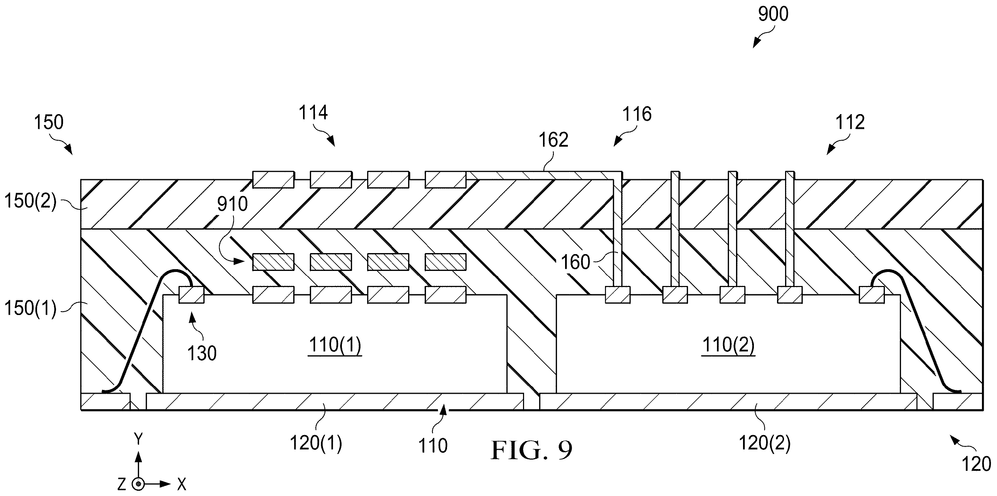

FIG. 9 shows an example packaged device 900 which is similar to the example packaged device 700 of FIG. 7. Like reference characters refer to the same or similar parts among the example packaged devices 700, 900.

As shown in FIG. 9, the communication coils 114 that are electrically coupled with the first semiconductor die 110(1) are die coils (part of the first semiconductor die 110(1)) and the communication coils 114 that are electrically coupled with the second semiconductor die 110(2) are molding compound coils (fabricated within the molding compound 112). Additionally, the example packaged device 900 includes individual segments 910 of high breakdown material disposed between the communication coils 114. The high breakdown material of the individual segments 910 has a higher dielectric strength than that of the molding compound 112.

Again, the individual segments 910 may be installed within the example packaged device 900 using standard techniques. In contrast to the example packaged device 700 in which the individual segments 710 are disposed within the upper layer 150(2) of molding material (e.g., see FIG. 7), the example packaged device 900 positions the individual segments 910 within the lower layer 150(1) of molding material thus enabling the upper layer 150(2) of molding material to be thinner along the Y-axis. Accordingly, the overall packaged device 900 may be thinner as well.

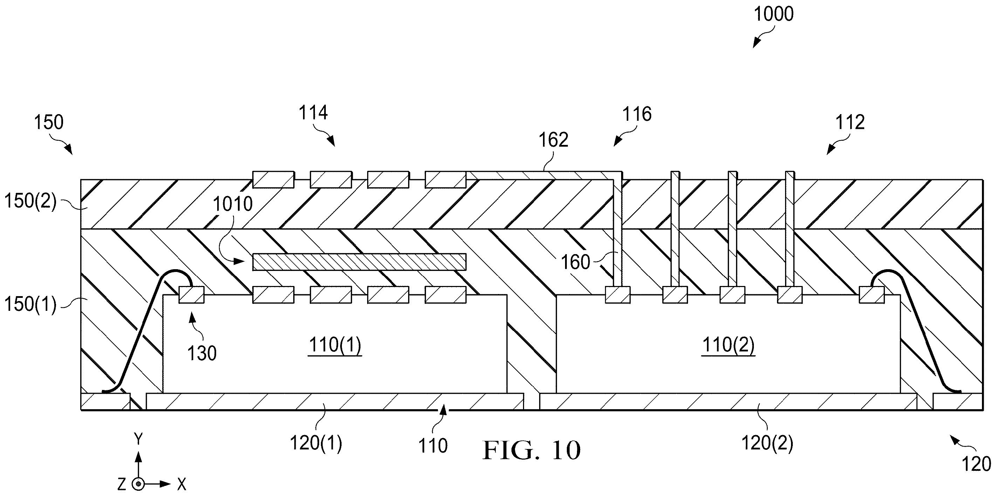

FIG. 10 shows an example packaged device 1000 which is similar to the example packaged device 800 of FIG. 8. Like reference characters refer to the same or similar parts among the example packaged devices 800, 1000.

As shown in FIG. 10, the communication coils 114 that are electrically coupled with the first semiconductor die 110(1) are die coils (part of the first semiconductor die 110(1)) and the communication coils 114 that are electrically coupled with the second semiconductor die 110(2) are molding compound coils (fabricated within the molding compound 112). Additionally, the packaged device 1000 includes a common segment 1010 of high breakdown material disposed between the multiple communication coils 114 electrically coupled with the first semiconductor die 110(1) and the multiple coils 114 electrically coupled with the second semiconductor die 110(2). Again, the high breakdown material of the common segment 1010 has a higher dielectric strength than that of the molding compound 112.

Again, the common segment 1010 may be installed within the example packaged device 1000 using standard techniques. In contrast to the example packaged device 800 in which the individual segments 810 are disposed within the upper layer 150(2) of molding material (e.g., see FIG. 8), the example packaged device 1000 positions the common segment 1010 within the lower layer 150(1) of molding material, thus enabling the upper layer 150(2) of molding material to be thinner along the Y-axis. Accordingly, the overall packaged device 1000 may be thinner as well.

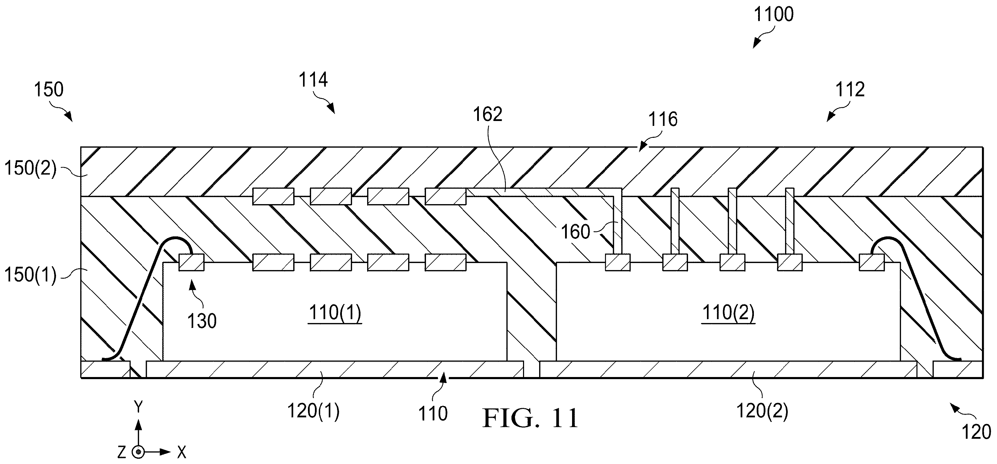

FIG. 11 shows an example packaged device 1100 which is similar to the earlier-described example packaged devices. Like reference characters refer to the same or similar parts among the packaged devices.

As shown in FIG. 11, the communication coils 114 that are electrically coupled with the first semiconductor die 110(1) are die coils (part of the first semiconductor die 110(1)) and the communication coils 114 that are electrically coupled with the second semiconductor die 110(2) are molding compound coils (fabricated within the molding compound 112). Additionally, the communication coils 114 (molding compound coils) that are electrically coupled with the second semiconductor die 110(2) are disposed between the lower layer 150(1) of molding compound and the upper layer 150(2) of molding material.

Furthermore, the TMV 160 from the second semiconductor die 110(2) does not penetrate completely through the molding compound 112 but only extends through the first layer 150(1). Also, the trace 162 between a communication coil 114 and the TMV 160 resides within the X-Z plane between the lower layer 150(1) and the upper layer 150(2). The TMV 160 and the trace 162 may be fabricated during the same metallization process that fabricates the molding compound coils and prior to adding the upper layer 150(2).

Here, the upper layer 150(2) of molding material serves as a protective conformal coating. In some embodiments, the upper layer 150(2) may be formed of different molding material than the lower layer 150(1) of molding material. In some embodiments, the upper layer 150(2) of molding material advantageously is not required for galvanic isolation thus removing a constraint on the thickness of the upper layer 150(2).

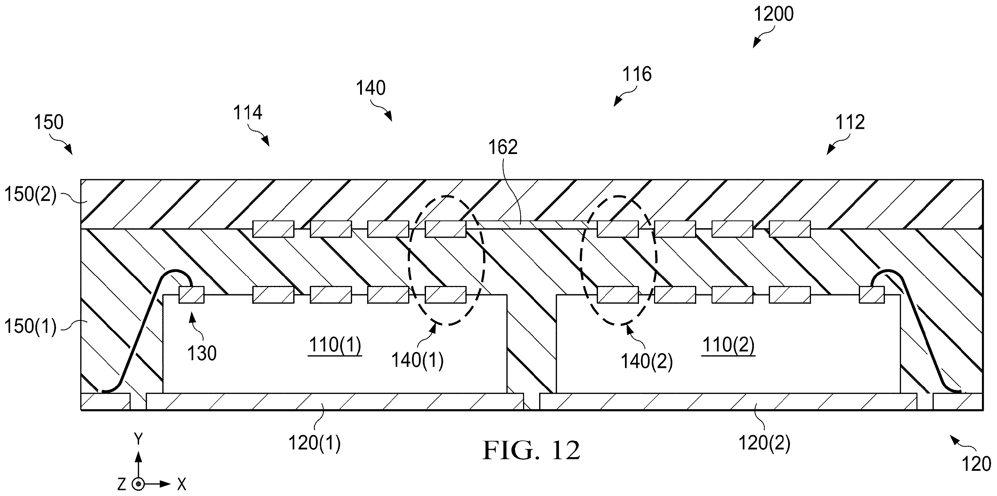

FIG. 12 shows an example packaged device 1200 which is similar to the example packaged device 1100 of FIG. 1. Like reference characters refer to the same or similar parts among the example packaged devices 1100, 1200.

As shown in FIG. 12, the communication coils 114 that are electrically coupled with the first semiconductor die 110(1) are die coils (part of the first semiconductor die 110(1)) and, likewise, the communication coils 114 that are electrically coupled with the second semiconductor die 110(2) are die coils (part of the second semiconductor die 110(2)). In this situation, the packaged device 1200 does not require TMVs.

Additionally, there are multiple inductively coupled coil pairs involved in conveying signals between the die coils. Along these lines and as shown in FIG. 12, other communication coils 114, which are molding compound coils, reside between the lower layer 150(1) and upper layer 150(2). Additionally, traces 162 electrically connect the communication coils 114 which are molding compound coils.

Along these lines, the cross-sectional view of FIG. 12 shows two communication coils 114, which are molding compound coils, electrically connected together via a trace 162. One of these communication coils 114 is inductively coupled with a communication coil 114 which is a die coil of the first semiconductor die 110(1) to form a first inductively coupled coil pair 140(1). Another of these communication coils 114 is inductively coupled with another communication coil 114 which is a die coil of the second semiconductor die 110(2) to form a second inductively coupled coil pair 140(2). During operation, a signal is able to propagate through both inductively coupled coil pairs 140(1), 140(2). Accordingly, GICL for this packaged device 1200 involves communications through multiple inductively coupled coil pairs 140.

Although only one trace 162 is shown in the particular cross-section of FIG. 12, it should be understood that the other molding compound coils are electrically connected via other traces 162. It should be further understood that the communication coils 114 which are molding compound coils and the associated traces 162 are disposed parallel to the X-Z plane between the first layer 150(1) and the second layer 150(2). That is, the upper layer 150(2) of molding material serves as a protective conformal coating.

In some embodiments, the upper layer 150(2) may be formed of different molding material than the lower layer 150(1) of molding material. Advantageously, the upper layer 150(2) of molding material is not required for galvanic isolation and thus removing a constraint on the thickness of the upper layer 150(2).

It should be understood that any of the features described above in connection with FIGS. 1 and 7 through 12 may be combined or used individually to provide other permutations, variants, etc. of packaged devices.

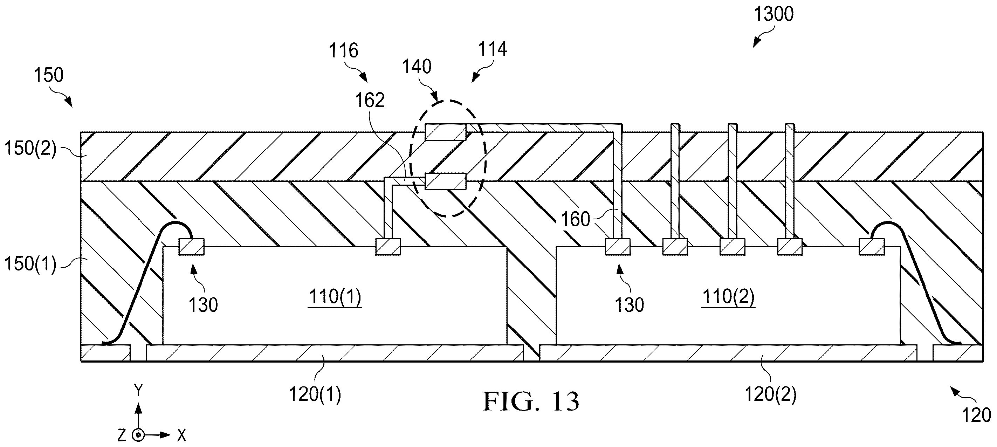

FIG. 13 is a simplified view 1300 illustrating how an inductively coupled coil pair 140 is provided for GICL between galvanically isolated semiconductor die 110 in accordance with one or more embodiments. This illustration shows how there is now freedom to fabricate communication coils 114 on the molding compound 112. Accordingly, component placement, the location of structures, package geometries, etc. are now adjustable simply based on product requirements.

The inductively coupled coil pair 140 includes two communication coils 114 fabricated within the molding compound 112. The communication coils 114 electrically couple with respective semiconductor die 110 through respective structures 116.

Along these lines, one communication coil 114 of the inductively coupled coil pair 140 electrically couples with the first semiconductor die 110(1) through a TMV 160 and a trace 162 fabricated within the first layer 150(1) of molding material. Along these lines, the communication coil 114 as well as the connecting TMV 160 and trace 162 may be fabricated after the first layer 150(1) of molding material is provided but before the second layer 150(2) of molding material is provided.

Additionally, the other communication coil 114 of the inductively coupled coil pair 140 electrically couples with the second semiconductor die 110(2) through another TMV 160 and another trace 162. Similarly, the other communication coil 114 as well as the other connecting TMV 160 and trace 162 may be fabricated after the second layer 150(2) of molding material is provided over the first layer 150(1) of molding material.

It should be understood that the TMV 160 that extends through both layers 150(1) and 150(2) may be fabricated in sections or all at once. For example, a lower section of this TMV 160 may be fabricated after the first layer 150(1) of molding material is provided but before the second layer 150(2) of molding material is provided. Along these lines, the lower section of the TMV 160 may be fabricated while fabricating the communication coil 114 and related structures 116 which electrically couple with the first semiconductor die 110(1).

Then, after the upper layer 150(2) of molding material is provided over the lower layer 150(1) of molding material, an upper section of the TMV 160 is fabricated along with the communication coil 114 and the trace 162 which electrically couple with the second semiconductor die 110(2). Here, there is a penetration through the upper layer 150(2) which intersects with the lower section of the TMV 160 enabling the upper and lower sections of the TMV 160 to electrically connect.

As another example, the TMV 160 that extends through both layers 150(1) and 150(2) may be fabricated all at once. Along these lines, a deep penetration is made from the top of the upper layer 150(2) of molding material through layers 150(1), 150(2) to a pad 130 on the second semiconductor die 110(2). The TMV 160 is then fabricated (e.g., via laser structuring).

It should be understood that the various thickness of the layers 150 may be adjusted for various applications and/or purposes. In accordance with certain embodiments, the thickness of the lower layer 150(1) is maximized to reduce interference between the communication coils 114 and the semiconductor die 110. In accordance with certain embodiments, the thickness of the upper layer 150(2) is adjusted to tune coil efficiency and high voltage isolation.

Additionally, it should be appreciated that the upper layer 150(2) of molding material is explained earlier as serving as a protective conformal coating. In some embodiments (or optionally), additional coating material is applied on the top for protection.

With the techniques described herein, it should be appreciated that the communication coils 114 for GICL can be located within the molding compound 112 thereby removing spacing constraints from the semiconductor die 110. Accordingly, the semiconductor die 110 may be made smaller and may be disposed in non-stacked arrangements (e.g., side-by-side). Furthermore, the packaged device 100 may have different geometries (e.g., thinner profiles), and so on.

For certain conventional integrated circuit devices, it should be appreciated that the coils are part of the silicon die and take up expensive real estate on semiconductor substrates which can include silicon wafers and other more expensive semiconductor substrates. For effective signal transfer, the coils may need to be of certain dimensions since the distance between top and bottom coils is around 175+/- um. Additionally, to increase isolation voltage, the distance between the coils must increase and so must the coil sizes impacting the silicon die size proportionally. For a larger distance between coils, there must be an increase in power and/or coil size to communicate effectively. Unfortunately, increases in coil dimension impacts overall die size and package size.

In accordance with one or more embodiments, an efficient GICL (galvanically isolated communication linkage) package structure enhances non-conductive signal transfer between semiconductor dies and shrinks silicon die dimensions. This is accomplished by fabricating coils in the mold compound and using mold compound as the isolation medium.

In accordance with one or more embodiments, a process fabricates coils in epoxy mold compound (EMC), thereby allowing the reduction of silicon die area. For example, there may be coils on two separate EMC layers with the EMC acting as high voltage isolation.

In accordance with one or more embodiments, GICL devices utilize high isolation voltage of 5kV or more. Semiconductor dies communicate with embedded coil windings facing each other in active mold packaging EMC.

In accordance with one or more embodiments, a galvanically isolated package having coils fabricated in the insulating molding compound is provided. To fabricate coils in layers of EMC, Laser Direct Structuring (LDS) of Active Mold Packaging (AMP EMC material is utilized).

Such embodiments enjoy packaging benefits where coils may be removed from silicon and transferred to the LDS EMC. Such an improvement may result in effectively shrinking silicon die sizes. Moreover, a fault tolerant package can be achieved without need for a third silicon die (e.g., some conventional packages may use a dedicated third die for die coil inductive coupling).

Additionally, there are assembly process cost savings. Along these lines, no external spacer is needed between dies to provide separation between the dies. Additionally, no die attach film is required between the dies. Furthermore, the top die does not have to be larger (e.g., for anticipated backgrinding) to increase wafer robustness and handling capability during assembly. Also, the dies do not need to be stacked but can be placed laterally instead.

Rather, there is no need for spacer overhang. Additionally, there is now freedom to fabricate coils on the LDS EMC with respect to location and size depending on the product requirements. Moreover, for the LDS EMC, the height may now be adjustable depending on the product requirements.

The description herein provides examples for the purposes of understanding and is not intended to limit the invention or the application and uses of the same. Furthermore, there is no intention to be bound by any expressed or implied theory presented herein.

Directional references such as "top," "bottom," "left," "right," "above," "below," and so forth, unless otherwise stated, are not intended to require any preferred orientation and are made with reference to the orientation of the corresponding figure or figures for purposes of illustration.

It will be appreciated that the steps of various processes described herein are non-limiting examples of suitable processes according to embodiments and are for the purposes of illustration. Systems and devices according to embodiments herein may use any suitable processes including those that omit steps described above, perform those steps and similar steps in different orders, and the like. It will also be appreciated that well-known features may be omitted for clarity.

Certain embodiments are directed to a packaged device which includes molding compound, a first semiconductor die disposed within the molding compound, and a second semiconductor die disposed within the molding compound. The molding compound galvanically isolates the first and second semiconductor dies. The packaged device further includes communication coils constructed and arranged to provide communication between the first and second semiconductor dies through inductive coupling, at least one of the communication coils being fabricated within the molding compound.

In accordance with one or more embodiments, the communications coils include first coils fabricated within the molding compound to enable communication with the first semiconductor die, and second coils fabricated within the molding compound to enable communication with the second semiconductor die. Additionally, the first coils and the second coils form inductively coupled coil pairs to enable communication between the first and second semiconductor dies and maintain galvanic isolation between the first and second semiconductor dies.

In accordance with one or more embodiments, the molding compound includes a lower layer of molding material disposed between the first semiconductor die and the first coils. The first coils are electrically coupled with the first semiconductor die through the lower layer of molding material. The molding compound further includes an upper layer of molding material disposed between the first coils and the second coils. The second coils are electrically coupled with the second semiconductor die through the upper layer and the lower layer of molding material.

In accordance with one or more embodiments, the communications coils includes a first coil fabricated within the molding compound and electrically coupled with the first semiconductor die, and a second coil fabricated within the molding compound and electrically coupled with the second semiconductor die. Additionally, the first coil and the second coil are adjacent to each other to form an inductively coupled coil pair. Furthermore, a portion of the molding compound is disposed between the first coil and the second coil to maintain galvanic isolation between the first semiconductor die and the second semiconductor die.

In accordance with one or more embodiments, the molding compound includes a lower layer of molding material disposed between the first semiconductor die and the first coil. The first coil is electrically coupled with the first semiconductor die through the lower layer of molding material. The molding compound further includes an upper layer of molding material disposed between the first coil and the second coil. The second coil is electrically coupled with the second semiconductor die through the upper layer and the lower layer of molding material.

In accordance with one or more embodiments, the communications coils includes a first coil disposed on a top surface of the first semiconductor die to enable communication with the first semiconductor die, and a second coil fabricated within the molding compound to enable communication with the second semiconductor die. Additionally, the first coil and the second coil are adjacent to each other to form an inductively coupled coil pair. Furthermore, a portion of the molding compound is disposed between the first coil and the second coil to maintain galvanic isolation between the first semiconductor die and the second semiconductor die.

In accordance with one or more embodiments, the second coil is electrically coupled with the second semiconductor die through the molding material.

In accordance with one or more embodiments, the packaged device further includes a third coil disposed on a top surface of the second semiconductor die, and a fourth coil fabricated within the molding compound and being electrically coupled with the second coil. The third coil and the fourth coil are adjacent to each other to form another inductively coupled coil pair. Additionally, another portion of the molding compound is disposed between the third coil and the fourth coil to maintain galvanic isolation between the first semiconductor die and the second semiconductor die.

In accordance with one or more embodiments, the molding compound includes a lower layer of molding material disposed between the first coil and the second coil. The second coil is electrically coupled with the second semiconductor die through the lower layer of molding material. The molding compound further includes an upper layer of molding material disposed above the lower layer of molding material, the second coil being disposed between the lower and upper layers of molding material.

In accordance with one or more embodiments, the molding compound has a first characteristic breakdown voltage value. Additionally, the packaged device further includes a segment of material having a second characteristic breakdown voltage value that is higher than the first characteristic breakdown voltage value. The segment of material is disposed between an inductively coupled coil pair of the communications coils, the inductively coupled coil pair including a communications coil fabricated within the molding compound.

In accordance with one or more embodiments, the segment of material is disposed between multiple inductively coupled coil pairs of the communications coils. Each of the multiple inductively coupled coil pairs includes a communications coil fabricated within the molding compound.

Certain other embodiments are directed to a method of providing a packaged device. The method includes providing molding compound around a first semiconductor die and a second semiconductor die. The molding compound galvanically isolates the first and second semiconductor dies. The method further includes fabricating at least one communication coil within the molding compound to enable communication between the first and second semiconductor dies through inductive coupling.

In accordance with one or more embodiments, providing the molding compound includes providing a lower layer of molding material around the first and second semiconductor dies. Additionally, fabricating at least one communication coil within the molding compound includes fabricating a lower layer coil on the lower layer of molding material.

In accordance with one or more embodiments, providing the molding compound further includes providing an upper layer of molding material over the lower layer of molding material, the lower layer coil being disposed between the upper and lower layers of molding material.

In accordance with one or more embodiments, fabricating at least one communication coil within the molding compound further includes fabricating an upper layer coil on the upper layer of molding material, the upper layer coil and the lower layer coil being adjacent to each other to form an inductively coupled coil pair. Additionally, a portion of the upper layer of molding material is disposed between the upper layer coil and the lower layer coil to maintain galvanic isolation between the first semiconductor die and the second semiconductor die.

In accordance with one or more embodiments, the upper layer of molding material has a first breakdown characteristic. Additionally, the method further includes providing a segment of material within the portion of the upper layer of molding material, the segment of material having a second breakdown characteristic that is higher than the first breakdown characteristic.

In accordance with one or more embodiments, fabricating the lower layer coil on the lower layer of molding material includes forming the lower layer coil adjacent to a die coil of one of the first and second semiconductor dies to enable the lower layer coil and the die coil to form an inductively coupled coil pair.

In accordance with one or more embodiments, the method further includes fabricating at least one through-molding via (TMV) to electrically couple a communication coil fabricated within the molding compound with one of the first and second semiconductor dies.

In accordance with one or more embodiments, providing the molding compound around the first semiconductor die and the second semiconductor die includes encapsulating the first and second semiconductor dies with an epoxy mold compound.

In accordance with one or more embodiments, fabricating at least one coil within the molding compound includes forming a communication coil within the molding compound during a metallization process.

The following examples pertain to further embodiments, from which numerous permutations and configurations will be apparent.

Example 1 includes a packaged device. The packaged device includes molding compound, a first semiconductor die disposed within the molding compound, a second semiconductor die disposed within the molding compound. The molding compound galvanically isolates the first and second semiconductor dies. The packaged device further includes communication coils constructed and arranged to provide communication between the first and second semiconductor dies through inductive coupling, at least one of the communication coils being fabricated within the molding compound.

Example 2 includes the subject matter of Example 1 wherein the communications coils include first coils fabricated within the molding compound to enable communication with the first semiconductor die, and second coils fabricated within the molding compound to enable communication with the second semiconductor die. Additionally, the first coils and the second coils form inductively coupled coil pairs to enable communication between the first and second semiconductor dies and maintain galvanic isolation between the first and second semiconductor dies.

Example 3 includes the subject matter of Example 2 wherein the molding compound includes a lower layer of molding material disposed between the first semiconductor die and the first coils. The first coils are electrically coupled with the first semiconductor die through the lower layer of molding material. The molding compound further includes an upper layer of molding material disposed between the first coils and the second coils. The second coils are electrically coupled with the second semiconductor die through the upper layer and the lower layer of molding material.

Example 4 includes the subject matter of Example 1 wherein the communications coils includes a first coil fabricated within the molding compound and electrically coupled with the first semiconductor die, and a second coil fabricated within the molding compound and electrically coupled with the second semiconductor die. Additionally, the first coil and the second coil are adjacent to each other to form an inductively coupled coil pair. Furthermore, a portion of the molding compound is disposed between the first coil and the second coil to maintain galvanic isolation between the first semiconductor die and the second semiconductor die.

Example 5 includes the subject matter of Example 4 wherein the molding compound includes a lower layer of molding material disposed between the first semiconductor die and the first coil. The first coil is electrically coupled with the first semiconductor die through the lower layer of molding material. The molding compound further includes an upper layer of molding material disposed between the first coil and the second coil. The second coil is electrically coupled with the second semiconductor die through the upper layer and the lower layer of molding material.

Example 6 includes the subject matter of Example 1 wherein the communications coils includes a first coil disposed on a top surface of the first semiconductor die to enable communication with the first semiconductor die, and a second coil fabricated within the molding compound to enable communication with the second semiconductor die. Additionally, the first coil and the second coil are adjacent to each other to form an inductively coupled coil pair. Furthermore, a portion of the molding compound is disposed between the first coil and the second coil to maintain galvanic isolation between the first semiconductor die and the second semiconductor die.

Example 7 includes the subject matter of Example 6 wherein the second coil is electrically coupled with the second semiconductor die through the molding material.

Example 8 includes the subject matter of Example 6 or Example 7 wherein the packaged device further includes a third coil disposed on a top surface of the second semiconductor die, and a fourth coil fabricated within the molding compound and being electrically coupled with the second coil. Additionally, the third coil and the fourth coil are adjacent to each other to form another inductively coupled coil pair. Furthermore, another portion of the molding compound is disposed between the third coil and the fourth coil to maintain galvanic isolation between the first semiconductor die and the second semiconductor die.

Example 9 includes the subject matter of any of Examples 6 through 8 wherein the molding compound includes a lower layer of molding material disposed between the first coil and the second coil. The second coil is electrically coupled with the second semiconductor die through the lower layer of molding material. The molding compound further includes an upper layer of molding material disposed above the lower layer of molding material, the second coil being disposed between the lower and upper layers of molding material.

Example 10 includes the subject matter of any of Examples 1 through 9 wherein the molding compound has a first characteristic breakdown voltage value. Additionally, the packaged device further includes a segment of material having a second characteristic breakdown voltage value that is higher than the first characteristic breakdown voltage value. The segment of material is disposed between an inductively coupled coil pair of the communications coils, the inductively coupled coil pair including a communications coil fabricated within the molding compound.

Example 11 includes the subject matter of Example 10 wherein the segment of material is disposed between multiple inductively coupled coil pairs of the communications coils. Each of the multiple inductively coupled coil pairs includes a communications coil fabricated within the molding compound.

Example 12 includes a method of providing a packaged device. The method includes providing molding compound around a first semiconductor die and a second semiconductor die. The molding compound galvanically isolates the first and second semiconductor dies. The method further includes fabricating at least one communication coil within the molding compound to enable communication between the first and second semiconductor dies through inductive coupling.

Example 13 includes the subject matter of Example 12 wherein providing the molding compound includes providing a lower layer of molding material around the first and second semiconductor dies. Additionally, fabricating at least one communication coil within the molding compound includes fabricating a lower layer coil on the lower layer of molding material.

Example 14 includes the subject matter of Example 13 wherein providing the molding compound further includes providing an upper layer of molding material over the lower layer of molding material, the lower layer coil being disposed between the upper and lower layers of molding material.

Example 15 includes the subject matter of Example 14 wherein fabricating at least one communication coil within the molding compound further includes fabricating an upper layer coil on the upper layer of molding material, the upper layer coil and the lower layer coil being adjacent to each other to form an inductively coupled coil pair. Additionally, a portion of the upper layer of molding material is disposed between the upper layer coil and the lower layer coil to maintain galvanic isolation between the first semiconductor die and the second semiconductor die.

Example 16 includes the subject matter of Example 15 wherein the upper layer of molding material has a first characteristic breakdown voltage value. Additionally, the method further includes providing a segment of material within the portion of the upper layer of molding material, the segment of material having a second characteristic breakdown voltage value that is higher than the first characteristic breakdown voltage value.

Example 17 includes the subject matter of Example 13 wherein fabricating the lower layer coil on the lower layer of molding material includes forming the lower layer coil adjacent to a die coil of one of the first and second semiconductor dies to enable the lower layer coil and the die coil to form an inductively coupled coil pair.

Example 18 includes the subject matter of any of Examples 12 through 17 wherein the method further includes fabricating at least one through-molding via (TMV) to electrically couple a communication coil fabricated within the molding compound with one of the first and second semiconductor dies.

Example 19 includes the subject matter of any of Examples 12 through 18 wherein providing the molding compound around the first semiconductor die and the second semiconductor die includes encapsulating the first and second semiconductor dies with an epoxy mold compound.

Example 20 includes the subject matter of any of Examples 12 through 19 wherein fabricating at least one coil within the molding compound includes forming a communication coil within the molding compound during a metallization process.

Other embodiments are directed to packages, packaging components, related processes, process flows, and so on. Some embodiments are directed to various methods, components, structures, and so on which involve coils fabricated within molding compound.

While various embodiments of the present disclosure have been particularly shown and described, it will be understood by those skilled in the art that various changes in form and details may be made therein without departing from the scope of the present disclosure as defined by the appended claims. Such modifications and enhancements are intended to belong to various embodiments of the disclosure.

## Claims

1. A packaged device, comprising:
molding compound;
a first semiconductor die disposed within the molding compound;
a second semiconductor die disposed within the molding compound, the molding compound galvanically isolating the first and second semiconductor dies; and
communication coils constructed and arranged to provide communication between the first and second semiconductor dies through inductive coupling, at least one of the communication coils being fabricated within the molding compound.

2. The packaged device of claim 1, wherein the communications coils include:
first coils fabricated within the molding compound to enable communication with the first semiconductor die, and
second coils fabricated within the molding compound to enable communication with the second semiconductor die; and
wherein the first coils and the second coils form inductively coupled coil pairs to enable communication between the first and second semiconductor dies and maintain galvanic isolation between the first and second semiconductor dies.

3. The packaged device of claim 2, wherein the molding compound includes:
a lower layer of molding material disposed between the first semiconductor die and the first coils, the first coils being electrically coupled with the first semiconductor die through the lower layer of molding material; and
an upper layer of molding material disposed between the first coils and the second coils, the second coils being electrically coupled with the second semiconductor die through the upper layer and the lower layer of molding material.

4. The packaged device of claim 1, wherein the communications coils includes:
a first coil fabricated within the molding compound and electrically coupled with the first semiconductor die, and
a second coil fabricated within the molding compound and electrically coupled with the second semiconductor die;
wherein the first coil and the second coil are adjacent to each other to form an inductively coupled coil pair; and
wherein a portion of the molding compound is disposed between the first coil and the second coil to maintain galvanic isolation between the first semiconductor die and the second semiconductor die.

5. The packaged device of claim 4, wherein the molding compound includes:
a lower layer of molding material disposed between the first semiconductor die and the first coil, the first coil being electrically coupled with the first semiconductor die through the lower layer of molding material; and
an upper layer of molding material disposed between the first coil and the second coil, the second coil being electrically coupled with the second semiconductor die through the upper layer and the lower layer of molding material.

6. The packaged device of claim 1, wherein the communications coils includes:
a first coil disposed on a top surface of the first semiconductor die to enable communication with the first semiconductor die, and
a second coil fabricated within the molding compound to enable communication with the second semiconductor die;
wherein the first coil and the second coil are adjacent to each other to form an inductively coupled coil pair; and
wherein a portion of the molding compound is disposed between the first coil and the second coil to maintain galvanic isolation between the first semiconductor die and the second semiconductor die.

7. The packaged device of claim 6, wherein the second coil is electrically coupled with the second semiconductor die through the molding material.

8. The packaged device of claim 6 or claim 7, further comprising:
a third coil disposed on a top surface of the second semiconductor die, and
a fourth coil fabricated within the molding compound and being electrically coupled with the second coil;
wherein the third coil and the fourth coil are adjacent to each other to form another inductively coupled coil pair; and
wherein another portion of the molding compound is disposed between the third coil and the fourth coil to maintain galvanic isolation between the first semiconductor die and the second semiconductor die.

9. The packaged device of any of claim 6 to claim 8, wherein the molding compound includes:
a lower layer of molding material disposed between the first coil and the second coil, the second coil being electrically coupled with the second semiconductor die through the lower layer of molding material, and
an upper layer of molding material disposed above the lower layer of molding material, the second coil being disposed between the lower and upper layers of molding material.

10. The packaged device according to any preceding claim, wherein the molding
compound has a first characteristic breakdown voltage value; and wherein the packaged device further comprises:
a segment of material having a second characteristic breakdown voltage value that is higher than the first characteristic breakdown voltage value, the segment of material being disposed between an inductively coupled coil pair of the communications coils, the inductively coupled coil pair including a communications coil fabricated within the molding compound.

11. The packaged device of claim 10, wherein the segment of material is disposed between multiple inductively coupled coil pairs of the communications coils, each of the multiple inductively coupled coil pairs including a communications coil fabricated within the molding compound.

12. A method of providing a packaged device, the method comprising:
providing molding compound around a first semiconductor die and a second semiconductor die, the molding compound galvanically isolating the first and second semiconductor dies; and
fabricating at least one communication coil within the molding compound to enable communication between the first and second semiconductor dies through inductive coupling.

13. The method of claim 12, wherein providing the molding compound includes:
providing a lower layer of molding material around the first and second semiconductor dies; and
wherein fabricating at least one communication coil within the molding compound includes:
fabricating a lower layer coil on the lower layer of molding material.

14. The method of claim 12 or claim 13, wherein providing the molding compound further includes:
providing an upper layer of molding material over the lower layer of molding material, the lower layer coil being disposed between the upper and lower layers of molding material.

15. The method of claim 14, wherein fabricating at least one communication coil within the molding compound further includes:
fabricating an upper layer coil on the upper layer of molding material, the upper layer coil and the lower layer coil being adjacent to each other to form an inductively coupled coil pair; and
wherein a portion of the upper layer of molding material is disposed between the upper layer coil and the lower layer coil to maintain galvanic isolation between the first semiconductor die and the second semiconductor die.
